# EUROPEAN PATENT APPLICATION

(11) **EP 4 814 512 A1**
(43) Date of publication of application: **30.09.2026**
(21) Application number: 25895684.6
(22) Date of filing: 19.11.2025
(51) Int. Cl.: G01R 31/392, G01R 31/382, G01R 31/396, G01R 31/367, G01R 19/10, G01R 19/165, G01R 19/00, G01R 31/52

(54) **APPARATUS AND METHOD FOR DIAGNOSING ANOMALY OF BATTERY SYSTEM**

(30) Priority: 20.11.2024 KR 20240166158
(71) Applicant: LG Energy Solution, Ltd., Seoul 07335 (KR)
(72) Inventor: HAN, Sangyub, Daejeon 34122 (KR)
(74) Representative: Goddar, Heinz J.
(86) International application number: PCT/KR2025/019148
(87) International publication number: WO 2026/111388

(57) **Abstract**

An anomaly diagnosis apparatus for diagnosing an anomaly of a battery system including a battery and a charging apparatus, according to an embodiment of the present invention, can individually calculate, during a charging process of the battery, difference values of first voltages of the charging apparatus and second voltages of the battery, which are measured at predetermined intervals, calculate a trend value on the basis of the difference values, and compare each of the difference values with the trend value so as to diagnose whether an anomaly is present in at least one of the battery and the charging apparatus.

## Description

### [Technical Field]

This application claims priority to and the benefit of Korean Patent Application No.10-2024-0166158 filed in the Korean Intellectual Property Office on November 20, 2024 the entire contents of which are incorporated herein by reference.

The present disclosure relates to an anomaly detection apparatus and method for a battery system, and more particularly, to an anomaly detection apparatus and method for a battery system that diagnoses whether an abnormality occurs in at least one of a battery, a charging device, and a connecting member electrically connecting the battery and the charging device during a charging process of the battery.

### [Background Art]

As fossil fuels become depleted and concern over environmental pollution intensifies, the importance of eco-friendly alternative energy sources is growing. Among various alternative energy sources, demand for rechargeable battery systems is rapidly increasing.

Battery systems, due to their capability for repeated charging and regeneration, are being applied as countermeasures to today's environmental regulations and high oil price issues, ranging from small devices like mobile phones and laptops to large industrial fields such as automobiles, robots, and energy storage devices.

Typically, battery systems can be charged using a charging device. However, if abnormalities occur during the charging process such as sudden charging interruption or generation of abnormal charging data, conventional methods require halting the battery system and analyzing each component for faults, which makes rapid anomaly diagnosis difficult and reduces measurement efficiency and reliability.

### [Detailed Description of the Invention]

### [Technical Problem]

To obviate one or more problems of the related art, embodiments of the present disclosure provide an anomaly detection apparatus.

To obviate one or more problems of the related art, embodiments of the present disclosure also provide an anomaly diagnosing method using the anomaly detection apparatus.

To obviate one or more problems of the related art, embodiments of the present disclosure also provide a battery system including the anomaly detection apparatus.

To obviate one or more problems of the related art, embodiments of the present disclosure also provide a medium recording a program for executing the method for diagnosing an anomaly on a computer.

### [Technical Solution]

In order to achieve the objective of the present disclosure, an anomaly detection apparatus for diagnosing whether a battery system, including a battery and a charging device, is abnormal, may include at least one processor and a memory configured to store at least one instruction executed by the at least one processor, and the at least one instruction may include an instruction to individually calculate, during a charging process of the battery, difference values between the first voltages of the charging device and the second voltages of the battery measured at predetermined intervals; an instruction to calculate a trend value based on the difference values; and an instruction to diagnose an anomaly in at least one of the battery and the charging device by comparing each of the difference values with the trend value.

Herein, the trend value may include either a median value or an average value of the difference values.

Furthermore, the instruction to calculate a trend value based on the difference values may include an instruction to calculate the trend value of the difference values when a number of measurement cycles reaches a predetermined number of times.

Here, the instruction to diagnose an anomaly in at least one of the battery and the charging device may include an instruction to diagnose whether at least one of the battery and the charging device is abnormal by comparing the difference between the difference value and the trend value with a predetermined threshold value for each measurement cycle.

Here, the instruction to diagnose whether at least one of the battery and the charging device is abnormal by comparing the difference between the difference value and the trend value with a predetermined threshold value for each measurement cycle may include an instruction to determine that an anomaly has occurred in a connecting member electrically connecting the charging device and the battery if the difference between the difference value and the trend value is equal to or greater than a first threshold value.

Meanwhile, the instruction to diagnose whether at least one of the battery and the charging device is abnormal by comparing the difference between the difference value and the trend value with a predetermined threshold value for each measurement cycle may include an instruction to determine a type of battery defect by comparing the difference between a second voltage value and the trend value with the first threshold value if the difference between the difference value and the trend value is less than the first threshold value.

According to one embodiment, the instruction to determine the type of battery defect may include an instruction to determine that a disconnection has occurred in a tab of the battery if the difference between the second voltage value and the trend value is equal to or greater than the first threshold value.

According to another embodiment, the instruction to determining the type of battery defect may include an instruction to determine that an internal short circuit has occurred in the battery if the difference between the second voltage value and the trend value is less than the first threshold value and less than a second threshold value.

Meanwhile, the battery may be charged by the charging device in a constant current manner.

Furthermore, the first voltage value may be a measured value of the voltage between the positive charging line and the negative charging line of the charging device.

Moreover, the second voltage value may be a measured value of the voltage between the positive and negative terminals of the battery.

According to another embodiment of the present disclosure, a method for diagnosing an anomaly, using an anomaly detection apparatus located in a battery system including a battery and a charging device, may include individually calculating, during a charging process of the battery, difference values between the first voltages of the charging device and the second voltages of the battery measured at predetermined intervals; calculating a trend value based on the difference values; and diagnosing an anomaly in at least one of the battery and the charging device by comparing each of the difference values with the trend value.

Here, the trend value may include either a median value or an average value of the difference values.

Furthermore, the calculating of the trend value based on the difference values may include calculating the trend value of the difference values when a number of measurement cycles reaches a predetermined number of times.

Here, the diagnosing of an anomaly in at least one of the battery and the charging device may include diagnosing whether at least one of the battery and the charging device is abnormal by comparing the difference between the difference value and the trend value with a predetermined threshold value for each measurement cycle.

Here, the diagnosing of whether at least one of the battery and the charging device is abnormal by comparing the difference between the difference value and the trend value with a predetermined threshold value for each measurement cycle may include determining that an anomaly has occurred in a connecting member electrically connecting the charging device and the battery if the difference between the difference value and the trend value is equal to or greater than a first threshold value.

Meanwhile, the diagnosing of whether at least one of the battery and the charging device is abnormal by comparing the difference between the difference value and the trend value with a predetermined threshold value for each measurement cycle may include determining a type of battery defect by comparing the difference between a second voltage value and the trend value with the first threshold value if the difference between the difference value and the trend value is less than the first threshold value.

According to one embodiment, the determining of the type of battery defect may include determining that a disconnection has occurred in a tab of the battery if the difference between the second voltage value and the trend value is equal to or greater than the first threshold value.

According to another embodiment, the determining of the type of battery defect may include determining that an internal short circuit has occurred in the battery if the difference between the second voltage value and the trend value is less than the first threshold value and less than a second threshold value.

According to another embodiment of the present disclosure, a battery system may include a battery; a charging device for charging the battery; and an anomaly detection apparatus for diagnosing whether at least one of the battery and the charging device is abnormal, wherein the anomaly detection apparatus is configured to individually calculate, during a charging process of the battery, difference values between the first voltages of the charging device and the second voltages of the battery measured at predetermined intervals; calculate a trend value based on the difference values; and diagnose an anomaly in at least one of the battery and the charging device by comparing each of the difference values with the trend value.

### [Advantageous Effects]

According to embodiments of the present disclosure, an apparatus and method for diagnosing an abnormality in a battery system, it is possible to enable rapid analysis and repair by identifying the specific configuration and defect type where an anomaly has occurred in the battery, the charging device, or their connecting components, based on a trend value derived from the respective voltage values of the battery and the charging device, when a charging abnormality occurs in the battery system during a battery charging process.

### [Brief Description of the Drawings]

FIG. 1 is a block diagram of a battery system according to embodiments of the present disclosure.
FIG. 2 is a circuit diagram of a battery and a charging device within a battery system according to one embodiment of the present disclosure.
FIG. 3 is a circuit diagram of a battery and a charging device within a battery system according to another embodiment of the present disclosure.
FIG. 4 is a block configuration diagram of an anomaly diagnostic device within a battery system according to embodiments of the present disclosure.
FIG. 5 is a flowchart of the anomaly detection method according to embodiments of the present disclosure.
FIG. 6 is a flowchart illustrating the step of individually calculating the difference values in the anomaly diagnosis method according to embodiments of the present disclosure.
FIG. 7 is a flowchart illustrating a step in the anomaly diagnosis method according to embodiments of the present disclosure, wherein each difference value is compared with a trend value to diagnose whether at least one of the battery and the charging device is abnormal.
FIG. 8 is a flowchart illustrating the step of determining the type of battery defect in the anomaly detection method according to embodiments of the present disclosure.
FIG. 9 is a battery charging graph for illustrating the anomaly detection method according to embodiments of the present disclosure.
FIG. 10 shows graphs for illustrating the anomaly detection method according to embodiments of the present disclosure.

| | | | |
|---|---|---|---|
| 100: | Battery | 200: | Charging Device |
| 210: | Power Source | 220: | Charging Voltage Measurement Device |
| 230: | Charging Current Measurement Device | | |
| 300: | Anomaly detection apparatus | | |
| 310: | Memory | 320: | Processor |
| 330: | Transceiver | 340: | Input Interface Device |
| 350: | Output Interface Device | 360: | Storage Devices |
| 370: | Bus | | |

### [Best Modes for Practicing the Disclosure]

The present disclosure may be modified in various forms and have various embodiments, and specific embodiments thereof are shown by way of example in the drawings and will be described in detail below. It should be understood, however, that there is no intent to limit the present disclosure to the specific embodiments, but on the contrary, the present disclosure is to cover all modifications, equivalents, and alternatives falling within the spirit and technical scope of the present disclosure. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present disclosure. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present disclosure belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

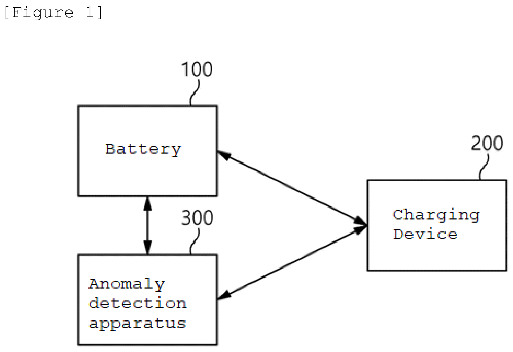

FIG. 1 is a block diagram of a battery system according to embodiments of the present disclosure.

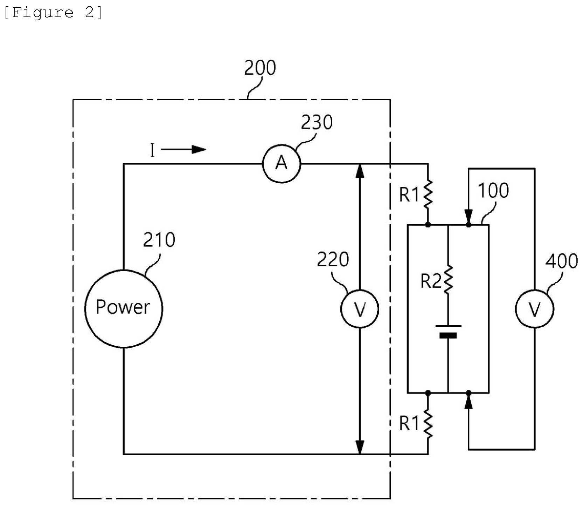

Referring to FIG. 1, the battery system may include a battery 100, a charging device 200, and an anomaly detection apparatus 300. In addition, the battery system may further include a battery voltage measurement device (see reference numeral 400 in FIG. 2).

Described in more detail by component, the battery 100 may be provided in the form of a battery cell or a battery assembly. Here, a battery assembly may refer to a configuration comprising a plurality of battery cells electrically connected by connecting members, forming an aggregate applied to a specific system or device to function as a power source. For example, the battery assembly may be a battery module, but the scope of the present disclosure is not limited to the described objects.

The battery 100 may be connected to a charging device 200, described later, via a connecting member, and charged by a charging current supplied from the charging device 200. For example, the connecting member may be provided as a bus bar in the form of a metal plate.

The charging device 200 may be a device for charging the battery 100. According to embodiments, the charging device 200 may be connected to the battery 100 and supply a maximum output current of a predetermined magnitude to the battery 100.

According to one embodiment, the charging device 200 may be connected to the battery 100 via a connecting member during an activation process step. Accordingly, the charging device 200 may be used during charge-discharge cycles performed repeatedly to evaluate the performance of the battery 100 prior to shipment.

According to another embodiment, the charging device 200 may be connected by a user to a connecting member of the battery 100 when charging is required to operate a shipped battery 100.

The anomaly detection apparatus 300 may diagnose whether an anomaly has occurred in at least one of the battery 100 and the charging device 200.

More specifically, according to embodiments, the anomaly detection apparatus 300 may individually measure the first voltages of the charging device 200 and the second voltages of the battery 100 at predetermined intervals during the charging process of the battery 100. Subsequently, the anomaly detection apparatus 300 may infer a trend of contact resistance in a connecting member between the charging device 200 and the battery 100 based on the individually measured first voltages of the charging device 200 and the second voltages of the battery 100. Accordingly, the anomaly detection apparatus 300 may determine whether a fault has occurred in at least one of the connecting members of the battery 100 and the charging device 200 based on the trend of the contact resistance.

Furthermore, the anomaly detection apparatus 300 may diagnose the cause of the battery failure based on the second voltages of the battery 100 measured at predetermined intervals.

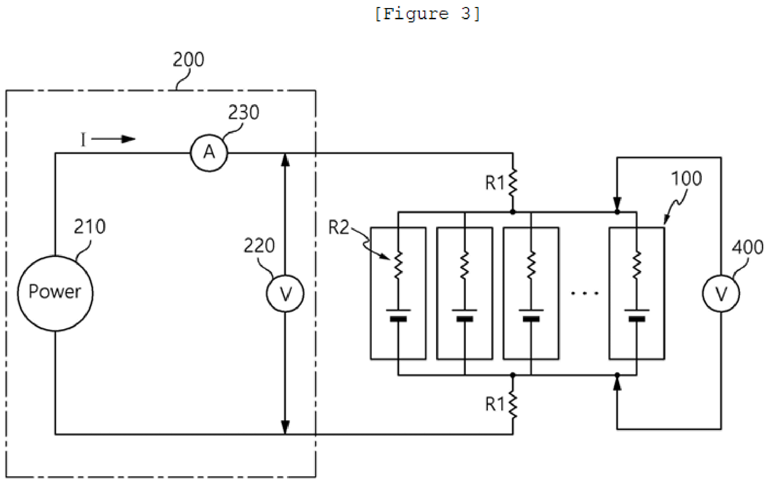

FIG. 2 is a circuit diagram of a battery and a charging device within a battery system according to one embodiment of the present disclosure, and FIG. 3 is a circuit diagram of a battery and a charging device within a battery system according to another embodiment of the present disclosure.

Referring to FIGS. 2 and 3, the battery 100 within the battery system may be connected to a battery voltage measurement device (400 in FIG. 3). According to the embodiment, the battery voltage measurement device 400 may have one end connected to the positive terminal of the battery 100 and another end connected to the negative terminal of the battery 100. Accordingly, the battery voltage measurement device 400 may measure a second voltage between the positive and negative terminals of the battery 100 in response to a control signal from the anomaly detection apparatus 300 and transmit it to the anomaly detection apparatus 300.

Meanwhile, the charging device 200 may be electrically connected to the battery 100 via the connecting member.

According to embodiments, the charging device 200 may include a power source 210 and a charging voltage measurement device 220. Furthermore, the charging device 200 may additionally include a charging current measurement device 230.

More specifically, the power source 210 may be configured to supply operating power to the charging device 200.

One end of the charging voltage measurement device 220 may be connected to a first node of the positive charging line formed between the power source 210 and the positive terminal of the battery 100, and the other end of the charging voltage measurement device 220 may be connected to a second node of the negative charging line formed between the power source 210 and the negative terminal of the battery 100. Accordingly, the charging voltage measurement device 220 may measure the first voltage between the positive charging line and the negative charging line of the charging device 200 based on a control signal from the anomaly detection apparatus 300. Subsequently, the charging voltage measurement device 220 may transmit the first voltage to the anomaly detection apparatus 300.

Meanwhile, one end of the current measurement device 230 may be connected to the power source 210, and the other end of the current measurement device 230 may be connected to the positive terminal of the battery 100. Accordingly, the current measurement device 230 may measure the magnitude of the current flowing from the power source 210 into the battery 100. However, the configuration of the current measurement device 230 is not essential and may be omitted.

Meanwhile, at least one first resistor (R1) disclosed in FIG. 2 may be the contact resistance of the connecting member, and the second resistor (R2) may be the internal resistance of the battery 100.

The anomaly detection apparatus 300 according to embodiments of the present disclosure may diagnose whether a fault has occurred in the connecting member between the battery 100 and the charging device 200 based on the magnitude change of at least one first resistor (R1) in the connecting member over a predetermined time period.

Furthermore, the anomaly detection apparatus 300 may infer the magnitude change of the first resistor (R1) in the connecting member over a predetermined time period based on the first voltage values of the charging device 200 and the second voltage values of the battery 100 measured at predetermined intervals. Based on this, the anomaly detection apparatus 300 may diagnose whether a contact fault has occurred in the connecting member connecting the battery 100 and the charging device 200.

More specifically, according to one embodiment, when the charging device 200 is used for charging and discharging during an activation process, the total resistance in the circuit of FIG. 3 may be expressed as the sum of resistance of the contact resistor, which is the first resistor (R1) at the connecting member, and resistance of the internal resistor of the battery 100, which is the second resistor (R2). Meanwhile, the magnitude of the total resistance may also be expressed as ratio of the difference between the first voltage value of the charging device 200 and the second voltage value of the battery 100, relative to the current (I) flowing through the circuit. Here, since the current (I) flowing through the circuit in FIG. 3 is constant, the anomaly detection apparatus 300 according to embodiments of the present disclosure may diagnose whether a contact fault has occurred in the connecting member between the battery 100 and the charging device 200 based on the difference values between the second voltage values of the battery 100 and the first voltage values of the charging device 200 measured periodically.

More specifically, according to another embodiment, as shown in FIG. 3, during operation of an assembly-type battery 100 in which multiple battery cells are connected by a connecting member, when the charging device 200 is connected to the connecting member by the user to charge the battery 100, the total resistance in the circuit of Fig. 3 may be expressed as the sum of resistance of the first resistor (R1) in the connecting member and resistance of the second resistors (R2) of the multiple battery cells within the battery 100. Meanwhile, the magnitude of the total resistance may also be expressed as ratio of the difference between the first voltage value of the charging device 200 and the second voltage value of the battery 100 including a plurality of battery cells, relative to the current (I) flowing through the circuit. As described earlier, the current (I) flowing through the circuit in FIG. 3 may be the same. Therefore, the anomaly detection apparatus 300 according to another embodiment of the present disclosure diagnoses faults based on the difference values between the second voltage values of the battery 100 and the first voltage values of the charging device 200, measured periodically. Here, the anomaly detection apparatus 300 according to another embodiment of the present disclosure may be provided as a configuration independent of the battery management system (BMS) or as a processor performing one function within the battery management system (BMS).

In summary, the anomaly detection apparatus 300 according to one embodiment and another embodiment of the present disclosure enables low-cost and highly reliable fault diagnosis of a battery system by confirming whether a fault has occurred in the connecting member linking the battery 100 and the charging device 200, without the need for a separate charging current measurement device 230.

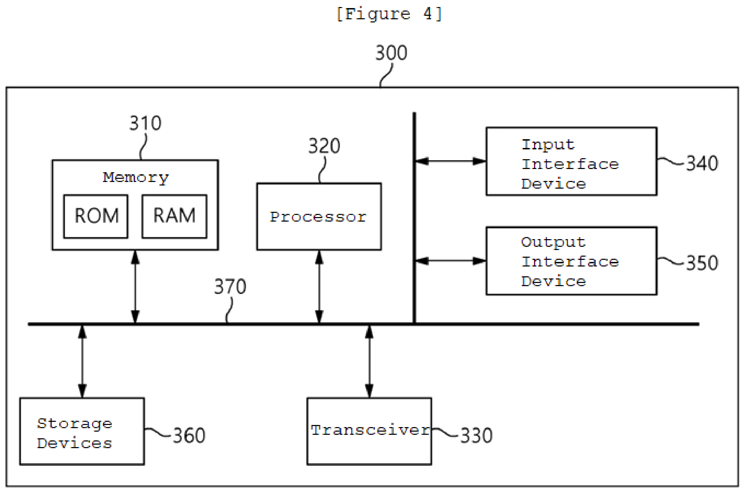

FIG. 4 is a block configuration diagram of an anomaly detection apparatus within a battery system according to embodiments of the present disclosure.

Referring to FIG. 4, the anomaly detection apparatus 300 according to embodiments of the present disclosure may include a memory 310, a processor 320, a transceiver 330, an input interface device 340, an output interface device 350, and a storage device 360.

According to the embodiment, respective components 310, 320, 330, 340, 350, 360 included in the anomaly detection apparatus 300 are connected by a bus (370) and can communicate with each other.

Among the components 310, 320, 330, 340, 350, 360, the memory 310 and storage device 360 may include at least one of volatile/transitory storage media and nonvolatile/non-transitory storage media. For example, the memory 310 and storage device 360 may comprise at least one of read-only memory (ROM) and random access memory (RAM), and may include electrically erasable programmable read-only memory (EEPROM).

Among these, the memory 310 may include at least one instruction executed by the processor 320.

According to embodiments, the at least one instruction may include an instruction to individually calculate, during a charging process of the battery, difference values between the first voltages of the charging device and the second voltages of the battery measured at predetermined intervals; an instruction to calculate a trend value based on the difference values; and an instruction to diagnose an anomaly in at least one of the battery and the charging device by comparing each of the difference values with the trend value.

Herein, the trend value may include either a median value or an average value of the difference values.

Furthermore, the instruction to calculate a trend value based on the difference values may include an instruction to calculate the trend value of the difference values when a number of measurement cycles reaches a predetermined number of times.

Here, the instruction to diagnose an anomaly in at least one of the battery and the charging device may include an instruction to diagnose whether at least one of the battery and the charging device is abnormal by comparing the difference between the difference value and the trend value with a predetermined threshold value for each measurement cycle.

Here, the instruction to diagnose whether at least one of the battery and the charging device is abnormal by comparing the difference between the difference value and the trend value with a predetermined threshold value for each measurement cycle may include an instruction to determine that an anomaly has occurred in a connecting member electrically connecting the charging device and the battery if the difference between the difference value and the trend value is equal to or greater than a first threshold value.

Meanwhile, the instruction to diagnose whether at least one of the battery and the charging device is abnormal by comparing the difference between the difference value and the trend value with a predetermined threshold value for each measurement cycle may include an instruction to determine a type of battery defect by comparing the difference between a second voltage value and the trend value with the first threshold value if the difference between the difference value and the trend value is less than the first threshold value.

According to one embodiment, the instruction to determine the type of battery defect may include an instruction to determine that a disconnection has occurred in a tab of the battery if the difference between the second voltage value and the trend value is equal to or greater than the first threshold value.

According to another embodiment, the instruction to determining the type of battery defect may include an instruction to determine that an internal short circuit has occurred in the battery if the difference between the second voltage value and the trend value is less than the first threshold value and less than a second threshold value.

Meanwhile, the battery may be charged by the charging device using a constant current method.

Furthermore, the first voltage value may be a measured value of the voltage between the positive charging line and the negative charging line of the charging device.

Moreover, the second voltage value may be a measured value of the voltage between the positive and negative terminals of the battery.

Meanwhile, the processor 320 may refer to a central processing unit (CPU), a graphics processing unit (GPU), or a dedicated processor on which the methods according to embodiments of the present disclosure are performed.

The processor 320 may execute at least one program command stored in the memory 310, as described above.

The battery system according to the embodiments of the present disclosure has been described above. Hereinafter, an anomaly diagnosis method based on the operation of the processor of the anomaly detection apparatus within the battery system will be described.

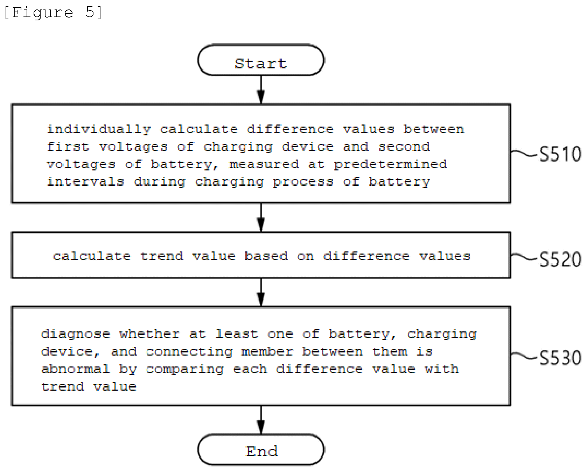

FIG. 5 is a flowchart of the anomaly detection method according to embodiments of the present disclosure.

Referring to FIG. 5, the processor 320 in the anomaly detection apparatus 300 according to embodiments of the present disclosure may individually calculate the difference values between the first voltages of the charging device 200 and the second voltages of the battery 100, measured at predetermined intervals during the charging process of the battery 100 (S510).

Subsequently, the processor 320 may calculate a trend value based on the difference values (S520). Here, the trend value may include any one of the median value, minimum value, maximum value, and average value of the difference values.

According to an example, the trend value may be the average value. Accordingly, the processor 320 may calculate the average value of the difference values until the number of periodic measurements (N) or the number of difference values reaches a predetermined reference value.

Thereafter, the processor 320 may diagnose whether at least one of the battery 100, the charging device 200, and connecting member, connecting the battery and the charging device, is abnormal by comparing each of the difference values with the trend value (S530).

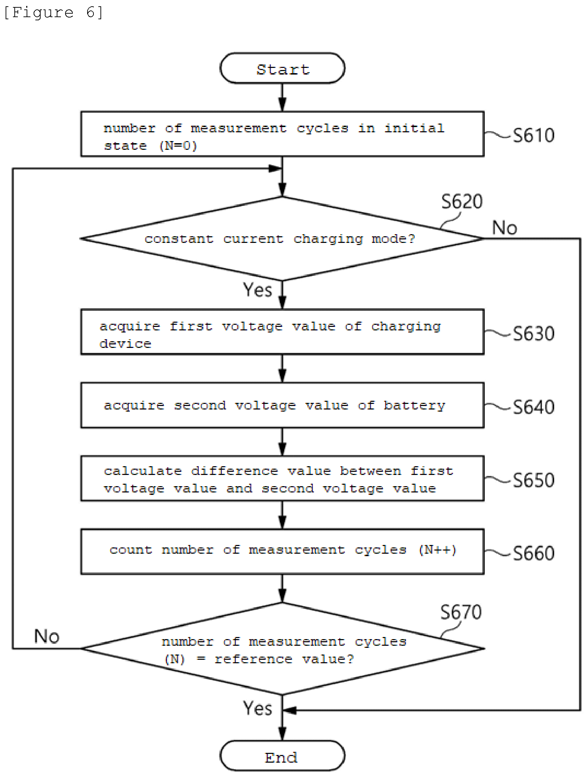

FIG. 6 is a flowchart illustrating the step of individually calculating the difference values in the anomaly diagnosis method according to embodiments of the present disclosure.

Referring to FIG. 6, the processor 320 within the anomaly detection apparatus 300 according to embodiments of the present disclosure may identify the charging mode of the battery 100 during a charging process of the battery 100.

More specifically according to the embodiment, the processor 320 may determine whether the battery 100 is being charged using a constant current (CC) charging mode when the battery 100 and the charging device 200 are in an initial state (N=0, S610) where they are electrically connected (S620).

Here, if the battery 100 is being charged using the constant current (CC) charging mode (Yes in S620), the processor 320 may acquire the first voltage value of the charging device 200 (S630).

More specifically, the processor 320 may transmit a voltage measurement control signal to the charging device 200 when the battery 100 is being charged using the constant current (CC) charging mode. Accordingly, the charging device 200 may measure the first voltage between the positive charging line and the negative charging line of the charging device 200 using the charging voltage measurement device 220 and transmit it to the anomaly detection apparatus 300. Therefore, the processor 320 may acquire the first voltage value measured from the charging device 200.

Subsequently, the processor 320 may acquire a second voltage value of the battery 100 (S640).

More specifically, the processor 320 may acquire the second voltage value of the battery 100 individually measured at predetermined intervals.

Described in more detail according to embodiments, the processor 320 may transmit a voltage measurement control signal to the battery 100. Accordingly, the battery 100 may measure the second voltage value between the positive and negative electrodes of the battery 100 using the battery voltage measurement device 400 and transmit it to the anomaly detection apparatus 300. Therefore, the processor 320 may acquire the second voltage value of the battery 100.

Subsequently, the processor 320 may calculate (S650) the difference value between the first voltage value of the charging device 200 and the second voltage value of the battery 100, and count (N++, S660) the number of measurement cycles (N), which has an initial value of 0.

Thereafter, the processor 320 may check whether the counted number of measurement cycles (N) has reached a predetermined reference value (S670).

Here, the processor 320 may repeatedly perform steps S620 to S670 at predetermined intervals until the counted number of measurement cycles (N) reaches the predetermined reference value, if the counted number of measurement cycles (N) is below the predetermined reference value. According to embodiments, the predetermined interval may be 60 seconds and the predetermined reference value may be 20 times. However, the processor 320 of the anomaly detection apparatus 300 according to embodiments of the present disclosure, without being limited to the disclosure, may individually calculate the difference values at predetermined intervals until the counted number of the difference values reaches the predetermined reference value, by counting the number of the difference values calculated in step S650.

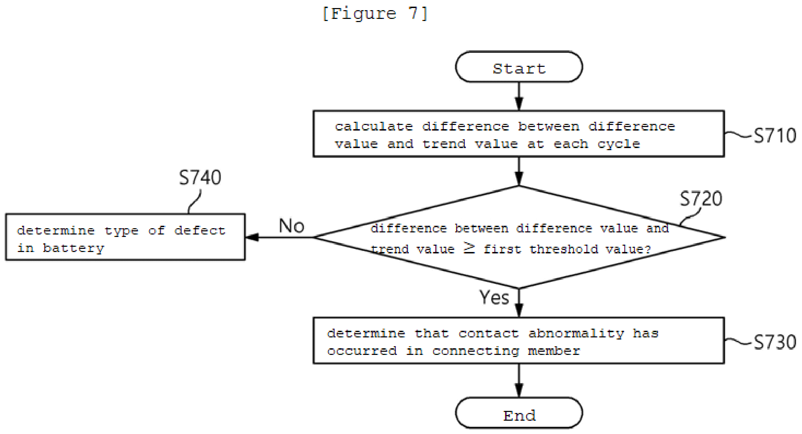

FIG. 7 is a flowchart illustrating a step in the anomaly diagnosis method according to embodiments of the present disclosure, wherein each difference value is compared with a trend value to diagnose whether at least one of the battery and the charging device is abnormal.

Referring to FIG. 7, the processor 320 may calculate the difference between the difference value and the trend value at each cycle (S710).

Subsequently, the processor 320 may compare the difference between the difference value and the trend value with a predetermined first threshold value (L1) (S720).

Thereafter, if the difference between the difference value and the trend value is greater than or equal to the first threshold value (L1) (Yes in S720), the processor 320 may determine that a contact abnormality has occurred in the connecting member electrically connecting the charging device 200 and the battery 100 (S730).

Described more specifically according to one embodiment, if the charging device 200 is a device used for charging and discharging during an activation process, if the difference between the difference value and the trend value is greater than or equal to the first threshold value (L1), the processor 320 may diagnose that a contact abnormality has occurred in the connecting member connecting the battery 100 and the charging device 200.

More specifically, according to another embodiment, if the charging device 200 is connected to a connecting member of the battery 100, which comprises multiple battery cells connected in an assembly configuration, to charge the battery 100, if the difference between the difference value and the trend value is greater than or equal to the first threshold value (L1), the processor 320 may diagnose that a contact abnormality has occurred in the connecting member connecting the battery 100 and the charging device 200, or in the connecting member electrically connecting the multiple battery cells within the battery 100.

Meanwhile, if the difference between the difference value and the trend value is below the first threshold value (L1) (No in S720), the processor 320 may determine the type of defect in the battery 100 (S740).

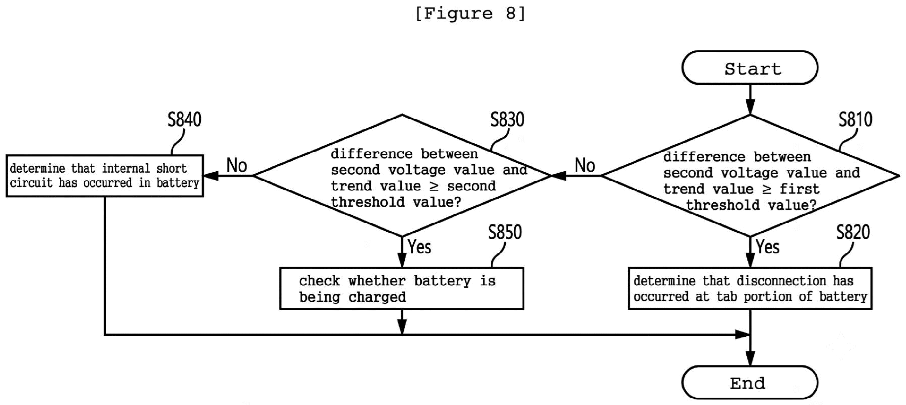

FIG. 8 is a flowchart illustrating the step of determining the type of battery defect in the anomaly detection method according to embodiments of the present disclosure.

Referring to FIG. 8, the processor 320 may compare the difference between the second voltage value and the trend value with the first threshold value (L1) for each cycle (S810), if the difference between the difference value and the trend value is less than the first threshold value (L1) (No in S720 in FIG. 7).

According to one embodiment, if the difference between the second voltage value and the trend value is equal to or greater than the first threshold value (L1) (Yes in S810), the processor 320 may determine that a disconnection has occurred at the tab portion of the battery 100 (S820).

Meanwhile, according to another embodiment, if the difference between the second voltage value and the trend value is less than the first threshold value (L1) (No in S810), the processor 320 may compare the second voltage value with a second threshold value (L2) (S830). For example, the second threshold value may be a negative value of the first threshold value.

Here, if the second voltage value is less than the second threshold value (L2) (No in S830), the processor 320 may determine that an internal short circuit has occurred in the battery 100 (S840).

On the other hand, if the second voltage value is equal to or greater than the second threshold value (Yes in S830), the processor 320 may check whether the battery 100 is being charged (S850).

Here, if the battery 100 is charging, the processor 320 may return to step S610 to determine the charging mode of the battery 100.

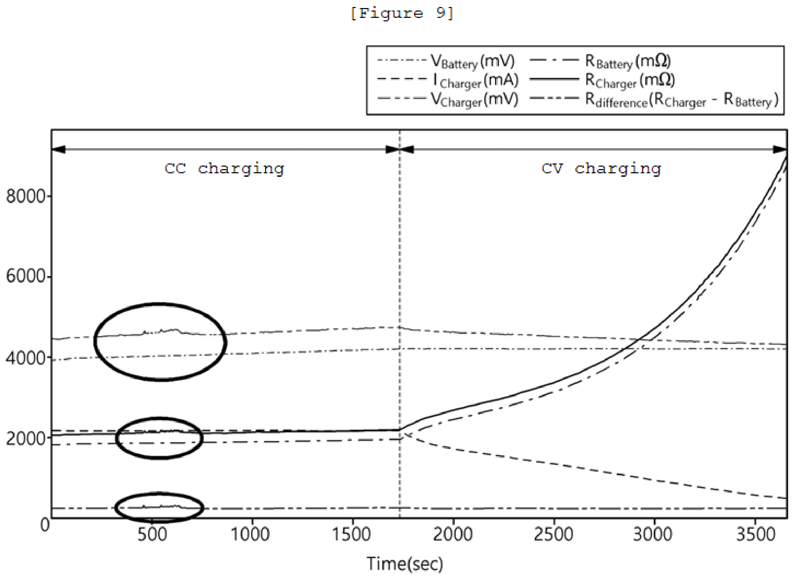

FIG. 9 is a battery charging graph for illustrating the anomaly detection method according to embodiments of the present disclosure.

Referring to FIG. 9, during the constant voltage (CV) charging phase, the battery 100 is charged by maintaining its voltage (VBattery) constant and controlling the magnitude of the current (Icharger). Therefore, when the battery 100 is undergoing constant voltage (CV) charging, it is difficult to detect changes in resistance (RCharger) between the battery 100 and the charging device 200 due to contact, based on ratio of the voltage change (Vcharger - VBattery) relative to the current (Icharger) flowing through the circuit.

Meanwhile, during the constant current (CC) charging phase, charging the battery 100 with a constant current (Icharger) may cause at least one of the first voltage value (Vcharger) of the charging device 200 and the second voltage value (VBattery) of the battery 100 to change. Therefore, the processor 320 within the anomaly detection apparatus 300 according to embodiments of the present disclosure may diagnose whether a contact abnormality has occurred in the connecting member between the battery 100 and the charging device 200 based on the resistance change (RCharger) due to the contact between the battery 100 and the charging device 200 and the resulting difference value (Rdifference) resulting therefrom, to diagnose whether a contact abnormality has occurred in the connecting member connecting the battery 100 and the charging device 200.

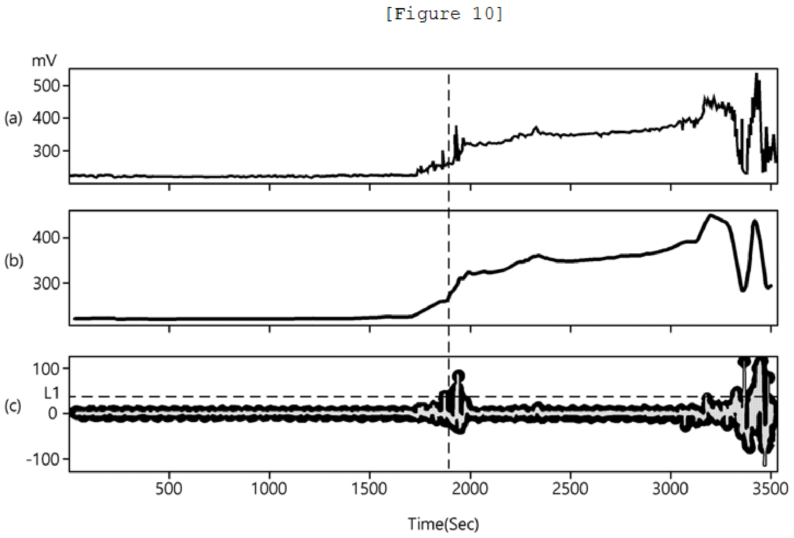

FIG. 10 shows graphs for illustrating the anomaly detection method according to embodiments of the present disclosure. More specifically, FIG. 10(a) is a graph showing the change in the difference value over time, FIG. 10(b) is a graph showing the change in the trend value over time, and FIG. 10(c) is a graph showing the change in the difference between the difference value and the trend value over time.

Referring to FIG. 10, when diagnosing whether an abnormality has occurred in the connecting member between the battery 100 and the charging device 200 by comparing the change in the difference value over time (see FIG. 10(a)) or the change in the trend value over time(see FIG. 10(b)) against a first threshold value (L1), changes in the difference value or trend value may occur due to aging of the connecting member or the presence of foreign matter, not necessarily contact abnormality of the connecting member, and thus, a false diagnosis of an abnormality may occur.

Meanwhile, the processor 320 within the anomaly detection apparatus 300 according to embodiments of the present disclosure, as shown in Fig. 10(c), can identify cases where a contact anomaly has occurred in the connecting member between the battery 100 and the charging device 200 by comparing the difference between the difference value and the trend value with the first threshold value (L1), which can improve diagnostic reliability.

The anomaly detection apparatus and method for a battery system according to the present disclosure have been described.

The anomaly detection apparatus and method for a battery system according to embodiments of the present disclosure, when a charge abnormality occurs in the battery system during the battery charging process, calculates the difference between the voltage value of the battery and the voltage value of the charging device, calculates a trend value based on this, compares the trend value with predetermined threshold values, and identifies the fault type and component where a fault has occurred in the battery, charging device, and their connecting members, thereby enabling rapid analysis and repair.

The operations of the method according to the embodiments of the present disclosure may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Furthermore, the computer-readable recording medium may include one or more of a volatile/transitory recording medium and a non-volatile/non-transitory recording medium.

In addition, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present disclosure has been described with reference to the exemplary embodiment of the present disclosure, but those skilled in the art may appreciate that the present disclosure may be variously corrected and changed within the range without departing from the spirit and the area of the present disclosure described in the appending claims.

## Claims

1. An anomaly detection apparatus for diagnosing whether a battery system, including a battery and a charging device, is abnormal, the apparatus comprising:
at least one processor; and
a memory configured to store at least one instruction executed by the at least one processor,
wherein the at least one instruction includes:
an instruction to individually calculate, during a charging process of the battery, difference values between the first voltages of the charging device and the second voltages of the battery measured at predetermined intervals;
an instruction to calculate a trend value based on the difference values; and
an instruction to diagnose an anomaly in at least one of the battery and the charging device by comparing each of the difference values with the trend value.

2. The apparatus of claim 1, wherein the trend value includes either a median value or an average value of the difference values.

3. The apparatus of claim 1, wherein the instruction to calculate a trend value based on the difference values includes:
an instruction to calculate the trend value of the difference values when a number of measurement cycles reaches a predetermined number of times.

4. The apparatus of claim 3, wherein the instruction to diagnose an anomaly in at least one of the battery and the charging device includes:
an instruction to diagnose whether at least one of the battery and the charging device is abnormal by comparing the difference between the difference value and the trend value with a predetermined threshold value for each measurement cycle.

5. The apparatus of claim 4, wherein the instruction to diagnose whether at least one of the battery and the charging device is abnormal by comparing the difference between the difference value and the trend value with a predetermined threshold value for each measurement cycle includes:
an instruction to determine that an anomaly has occurred in a connecting member electrically connecting the charging device and the battery if the difference between the difference value and the trend value is equal to or greater than a first threshold value.

6. The apparatus of claim 4, wherein the instruction to diagnose whether at least one of the battery and the charging device is abnormal by comparing the difference between the difference value and the trend value with a predetermined threshold value for each measurement cycle includes:
an instruction to determine a type of battery defect by comparing the difference between a second voltage value and the trend value with the first threshold value if the difference between the difference value and the trend value is less than a first threshold value.

7. The apparatus of claim 6, wherein the instruction to determine the type of battery defect includes:
an instruction to determine that a disconnection has occurred in a tab of the battery if the difference between the second voltage value and the trend value is equal to or greater than the first threshold value.

8. The apparatus of claim 6, wherein the instruction to determine the type of battery defect includes:
an instruction to determine that an internal short circuit has occurred in the battery if the difference between the second voltage value and the trend value is less than the first threshold value and less than a second threshold value.

9. The apparatus of claim 1, wherein the battery is charged by the charging device in a constant current manner.

10. The apparatus of claim 1, wherein the first voltage value is a measured value of the voltage between the positive charging line and the negative charging line of the charging device.

11. The apparatus of claim 1, wherein the second voltage value is a measured value of the voltage between the positive and negative terminals of the battery.

12. A method for diagnosing an anomaly using an anomaly detection apparatus located in a battery system including a battery and a charging device, the method comprising:
individually calculating, during a charging process of the battery, difference values between the first voltages of the charging device and the second voltages of the battery measured at predetermined intervals;
calculating a trend value based on the difference values; and
diagnosing an anomaly in at least one of the battery and the charging device by comparing each of the difference values with the trend value.

13. The method of claim 12, wherein the trend value includes either a median value or an average value of the difference values.

14. The method of claim 12, wherein the calculating of the trend value based on the difference values includes:
calculating the trend value of the difference values when a number of measurement cycles reaches a predetermined number of times.

15. The method of claim 14, wherein the diagnosing of an anomaly in at least one of the battery and the charging device includes:
diagnosing whether at least one of the battery and the charging device is abnormal by comparing the difference between the difference value and the trend value with a predetermined threshold value for each measurement cycle.

16. The method of claim 15, wherein the diagnosing of whether at least one of the battery and the charging device is abnormal by comparing the difference between the difference value and the trend value with a predetermined threshold value for each measurement cycle includes:
determining that an anomaly has occurred in a connecting member electrically connecting the charging device and the battery if the difference between the difference value and the trend value is equal to or greater than a first threshold value.

17. The method of claim 15, wherein the diagnosing of whether at least one of the battery and the charging device is abnormal by comparing the difference between the difference value and the trend value with a predetermined threshold value for each measurement cycle includes:
determining a type of battery defect by comparing the difference between a second voltage value and the trend value with the first threshold value if the difference between the difference value and the trend value is less than a first threshold value.

18. The method of claim 17, wherein the determining of the type of battery defect includes:
determining that a disconnection has occurred in a tab of the battery if the difference between the second voltage value and the trend value is equal to or greater than the first threshold value.

19. The method of claim 17, wherein the determining of the type of battery defect includes:
determining that an internal short circuit has occurred in the battery if the difference between the second voltage value and the trend value is less than the first threshold value and less than a second threshold value.

20. A battery system comprising:
a battery;
a charging device for charging the battery; and
an anomaly detection apparatus for diagnosing whether at least one of the battery and the charging device is abnormal,
wherein the anomaly detection apparatus is configured to:
individually calculate, during a charging process of the battery, difference values between the first voltages of the charging device and the second voltages of the battery measured at predetermined intervals;
calculate a trend value based on the difference values; and
diagnose an anomaly in at least one of the battery and the charging device by comparing each of the difference values with the trend value.

21. A computer-readable medium having recorded thereon a program for executing the method according to any one of claims 12 to 19 on a computer.
